Europäisches Patentamt

European Patent Office

Office européen des brevets

(11) Veröffentlichungsnummer: **0 374 299**
**A1**

## (12) EUROPÄISCHE PATENTANMELDUNG

(21) Anmeldenummer: **88121551.1**

(22) Anmeldetag: **23.12.88**

(51) Int. Cl.5: **H01L 39/24, C04B 35/00, C23D 5/00**

(43) Veröffentlichungstag der Anmeldung:
**27.06.90 Patentblatt 90/26**

(84) Benannte Vertragsstaaten:
**AT CH DE FR GB IT LI NL SE**

(71) Anmelder: **Siemens Aktiengesellschaft**
**Wittelsbacherplatz 2**
**D-8000 München 2(DE)**

(72) Erfinder: **Günther, Andreas, Dipl.-Ing.**
**Geschwister-Scholl-Strasse 6**
**D-8520 Erlangen(DE)**
Erfinder: **Assmann, Helmut, Dr. Dipl.-Phys.**
**Schwabachstrasse 13**
**D-8524 Dormitz(DE)**

(54) **Verfahren zum Herstellen eines hochtemperatur-supraleitenden Bauteiles.**

(57) Die Erfindung betrifft ein Verfahren zum Herstellen eines hochtemperatursupraleitenden Bauteiles, das aus einem mit supraleitendem, keramischem Material beschichteten Trägermetall besteht. Es ist vorgesehen, daß das keramische Material in Emailliertechnik oder in einer Kombination aus Emailliertechnik und Glaskeramiktechnik auf das Trägermetall aufgebracht wird. Die hochtemperatursupraleitenden Eigenschaften der Emailschicht (2) werden beispielsweise in einer glaskeramischen Wärmebehandlung eingestellt. Die mit diesem Verfahren hergestellten Bauteile können leitend verbunden werden und eignen sich zum Aufbau einer hochtemperatursupraleitenden Verbindungsleitung.

EP 0 374 299 A1

FIG 1

## Verfahren zum Herstellen eines hochtemperatur-supraleitenden Bauteiles

Die Erfindung betrifft ein Verfahren zum Herstellen eines hochtemperatursupraleitenden Bauteiles und ein mit diesem Verfahren hergestelltes Bauteil, das aus einem mit supraleitendem keramischem Material beschichteten Trägermetall besteht.

Alle bisher gefundenen Materialien, die auch bei hohen Temperaturen supraleitend sind, haben keramische Struktur. Hohe Temperaturen sind dabei Temperaturen über 77 K. Um die bekannten Keramiken in einen supraleitenden Zustand zu bringen, reicht eine Kühlung mit flüssigem Stickstoff aus, was eine wirtschaftliche Nutzung der Supraleitung ermöglicht. Die bekannten supraleitenden Keramiken sind aber wie alle Keramiken sehr spröde und somit nur sehr schwer formbar. Eine Herstellung von Verbindungsleitungen allein aus dem keramischen Material ist nicht durchführbar. Daher ist es notwendig, die bei hohen Temperaturen supraleitende Materialien auf ein Trägermetall aufzubringen.

Ein Verfahren zum Aufbringen von Schichten aus hochtemperatur-supraleitendem Material auf Substrate ist in der deutschen Patentanmeldung P 38 06 177.5 bereits vorgeschlagen worden. Dabei wird in einem zweistufigen, thermisches Spritzen genannten Verfahren pulverförmiges supraleitendes Material zunächst mit hoher Geschwindigkeit auf ein Substrat aufgespritzt und anschließend einer Wärmebehandlung unterzogen.

Dieses Verfahren zur Herstellung von Hochtemperatur-Supraleitern erfordert aufwendige und damit teuere Geräte. Außerdem sind die Energiekosten für die Fertigung sehr hoch, so daß das Herstellen von Hochtemperatur-Supraleitern unwirtschaftlich ist.

Der Erfindung lag die Aufgabe zugrunde, ein neues Verfahren zum Herstellen eines hochtemperatursupraleitenden Bauteiles zu entwickeln, das mit einfachen Mitteln zuverlässig arbeitende Hochtemperatur-Supraleiter zu fertigen gestattet. Es sollen große Mengen Hochtemperatur-Supraleiter für den kommerziellen Einsatz zur Verfügung gestellt werden.

Die Technik der Emailherstellung und der Emaillierung ist seit langer Zeit bekannt. So ist aus "Enzyclopädie der Naturwissenschaften und der Technik" zu entnehmen, daß zur Emailherstellung die Grundstoffe zunächst geschmolzen werden und daß die Schmelze dann zerkleinert wird. Auf diese Weise wird eine sogenannte Fritte gewonnen. Zu emaillierende Metalle werden zunächst gereinigt und gebeizt. Die Fritte wird dann beispielsweise durch Tauchen, Gießen oder Spritzen aufgebracht. Danach erfolgt das Einbrennen des Emailauftrages.

Durch chemische und physikalische Vorgänge beim Einbrennen wird eine fest haftende Emailschicht erzeugt.

Bekannte Emaillierverfahren werden beispielsweise bei der Herstellung von Haushaltsgeräten eingesetzt. Ein ähnliches Verfahren liegt auch der Herstellung von glaskristallinen Emails zugrunde.

Die gestellte Aufgabe wird erfindungsgemäß dadurch gelöst, daß das supraleitende, keramische Material in Emailliertechnik oder in einer Kombination aus Emailliertechnik und Glaskeramiktechnik auf das Trägermetall aufgebracht wird.

Mit dem Einsatz der als solchen bekannten Emailliertechnik zum Herstellen eines hochtemperatursupraleitenden Bauteiles wird der Vorteil erzielt, daß bei niedrigen Schmelztemperaturen und folglich mit geringem Energieaufwand zuverlässige, feste Verbindungen eines supraleitenden keramischen Materials mit einem Trägermetall herzustellen sind. Sowohl die Kosten für die technisch einfachen Geräte zur Durchführung des Verfahrens als auch die anfallenden Energiekosten sind sehr gering. Trotzdem wird eine gegen mechanische Einwirkungen stabile Beschichtung erzeugt. Durch den Einsatz der Emailliertechnik wird vorteilhaft das Herstellen von hochtemperatursupraleitenden Bauteilen als Massengut im Fließbandverfahren ermöglicht.

Zur Durchführung des erfindungsgemäßen Verfahrens werden beispielsweise anorganische Verbindungen, die Komponenten eines supraleitenden, keramischen Materials sind, geschmolzen und die Schmelze wird dann zur Herstellung einer Fritte pulverisiert. Die Fritte wird dann auf das Trägermetall als Schicht aufgebracht. Anschließend wird das mit der Fritte versehene Trägermetall einer Wärmebehandlung unterzogen. Diese Wärmebehandlung umfaßt z.B. eine Änderung der Temperatur und des Sauerstoffpartialdruckes abhängig von der Zeit. Physikalisch erfolgt Schmelzen, Keimbildung und Kristallisation. Eine so gebildete hochtemperatursupraleitende Emailschicht oder Glaskeramik-Emailschicht ist wie jede andere Emailschicht fest mit dem Trägermetall verbunden. Ein mit diesem Verfahren hergestelltes hochtemperatur-supraleitendes Bauteil ist wegen der Kombination der mechanischen Tragfähigkeit des Trägermetalls mit der Stabilität der fest mit dem Trägermetall verbundenen hochtemperatursupraleitenden Emailschicht für verschiedenartige Anwendungen, insbesondere auch für eine Übertragungsleitung, die über eine große Distanz zu verlegen ist, geeignet.

Beispielsweise werden der Fritte Zusatzstoffe zur Modifizierung des Herstellungsverfahrens und der Emaileigenschaften zugefügt. Die Zusatzstoffe beeinflussen den Schmelzpunkt, die Viskosität, die Keimbildungs- und Kristallisationsvorgänge, die Haftfähigkeit des Emails oder die elektrischen Eigenschaften des Emails.

Beispielsweise werden vor dem Aufbringen auf das Trägermetall die Partikel der Fritte mit elektrisch isolierenden Schichten versehen. Das Aufbringen der Schichten kann elektrostatisch erfolgen. Durch die elektrisch isolierenden Schichten auf den Partikeln der Fritte wird eine verbesserte Auftragung und Haftung der Frittenpartikel auf dem Trägermetall erreicht.

Beispielsweise geeignete Verfahren zum Aufbringen der Fritte auf das Trägermetall sind elektrostatisches Aufbringen, Schlikkertauchen oder Elektrophorose. Diese und weitere Verfahren sind in dem Buch von Petzold und Pöschmann "Email und Emailliertechnik", Springer Verlag 1987, beschrieben. Diese Verfahren zum Aufbringen der Fritte sind schnell und kostengünstig durchführbar.

Eine glaskeramische Wärmebehandlung wird beispielsweise in folgender Weise durchgeführt:

Die Fritte wird aufgeschmolzen und durch Abschrecken und damit verbundenes Abkühlen auf eine Anlaßtemperatur glasig erhalten. Dann folgt unter einem für die Keimbildung erforderlichen Sauerstoffpartialdruck eine Erwärmung auf eine Keimbildungstemperatur. Danach wird die Fritte unter einem für die Kristallisation erforderlichen Sauerstoffpartialdruck und bei einer geeigneten höheren Kristallisationstemperatur auskristallisiert.

Ein weiteres Beispiel für die glaskeramische Wärmebehandlung sieht folgendes vor:

Die Fritte wird aufgeschmolzen und durch Abschrecken gleich unter dem Keimbildungs-Sauerstoffpartialdruck sofort auf die Keimbildungstemperatur gebracht. Dann wird die Fritte unter dem Kristallisations-Sauerstoffpartialdruck und bei Kristallisationstemperatur auskristallisiert.

Nach einem anderen Beispiel wird eine Wärmebehandlung in folgender Weise durchgeführt.:

Die Fritte wird aufgeschmolzen und gleich unter dem Kristallisations-Sauerstoffpartialdruck auf Kristallisationstemperatur gebracht. Dann wird die Fritte unter Einwirkung eines Kristallisationsförderers auskristallisiert. Der Kristallisationsförderer wirkt hierbei als Keimbildner.

Als weiteres Beispiel wird die Fritte unter einem Gas oder Gasgemisch mit sehr niedrigem Sauerstoffpartialdruck aufgeschmolzen. Bei gleicher Temperatur wird dieses Gas durch ein anderes Gasgemisch mit einem bestimmten Kristallisations-Sauerstoffpartialdruck ersetzt. Allein dadurch kommt es zur Kristalllisation, da der Kristallisationspunkt unter Gasen mit unterschiedlichem Sauerstoffpartialdruck bei unterschiedlichen Temperaturen liegt.

Zur Verbesserung des Keimbildungsprozesses kann beispielsweise, auch in den anderen genannten Fällen, ein Keimbildungsförderer eingesetzt werden.

In den ersten beiden Fällen liegt die Keimbildungstemperatur im allgemeinen unter der Kristallisationstemperatur.

In allen drei Fällen ist es günstig, wenn die Kristallisation zu einer texturierten Schicht führt, wobei die Schichtdicke maßgeblich für die Güte der Textur ist. Dünne Schichten bilden eine stärkere Textur aus als dicke Schichten. Eine andere Möglichkeit, die Texturierung zu fördern, ist die kristallographisch augerichtete Anordnung von Kristallisationsförderern, wobei der Kristallisationsförderer ein kristallographisch ausgesuchtes Material ist. Die Textur kann aber beispielsweise auch durch die kristallographischen Eigenschaften des Trägermetalls erreicht werden.

Ein mit dem erfindungsgemäßen Verfahren hergestelltes hochtemperatursupraleitendes Bauteil besteht aus einem Trägermetall, das mit einem in Emailliertechnik aufgebrachten supraleitenden, keramischen Material beschichtet ist.

Das Trägermetall hat beispielsweise die Form eines Bleches, eines Bandes oder eines Rohres. Das Rohr hat beispielsweise einen runden, einen kastenförmigen oder einen gewellten Querschnitt. Beispielsweise ist das Rohr wabenförmig unterteilt. Eine Verbindungsleitung kann aus einer Kombination der obengenannten Trägermetallformen bestehen.

Das Trägermetall kann einseitig oder beidseitig beschichtet sein. Die supraleitende Emailschicht kann beispielsweise zum Schutz gegen chemische und mechanische Einwirkungen mit einem geeigneten Material, z.B. Kunststoff, getränkt oder beschichtet sein.

Die Form des zu emaillierenden Trägermetalles ist auszuwählen im Hinblick auf den Einsatzort eines hochtemperatursupraleitenden Bauteiles. Beschichtete Bleche eignen sich für supraleitende Abschirmungen oder für den Aufbau von Spulen. Rohre eignen sich besonders für supraleitende Verbindungsleitungen, wobei das Kühlmittel, das bei Hochtemperatur-Supraleitern flüssiger Stickstoff ist, im Inneren des Rohres fließt. Ein Verfahren und eine Einrichtung zur Herstellung einer supraleitenden Verbindungsleitung zur Übertragung elektrischer Energie über große Entfernungen ist in der deutschen Patentanmeldung P 38 084 74.0 bereits vorgeschlagen worden.

Ein geeignetes Trägermetall ist beispielsweise Kupfer, es sind aber auch Edelstähle oder Kupferlegierungen verwendbar.

Als supraleitendes, keramisches Material sind alle bisher bekannten bei hohen Temperaturen supraleitenden Keramiken einsetzbar. Beispielsweise ist das supraleitende keramische Material Y-Ba-Cu-Oxid, Bi-Sr-Ca-Cu-Oxid oder Tl-Ba-Ca-Cu-Oxid.

Eine mit dem erfindungsgemäßen Verfahren hergestellte Hochtemperatur-Supraleitung besteht beispielsweise aus mehreren Bauteilen aus Trägermetall, auf die supraleitendes, keramisches Material in Emailliertechnik aufgebracht ist. Diese Bauteile sind aneinanderfügbar. Geeignete Fügetechniken für emaillierte Bauteile sind bekannt, beispielsweise aus der DE-AS 17 71 039.

Dadurch, daß mehrere emaillierte Teile unter Gewährleistung einer ununterbrochenen Emailschicht und damit einer ununterbrochenen Supraleitung durch die Emailschicht aneinanderzufügen sind, wird der Vorteil erzielt, daß lange Verbindungsleitungen, die für die Energieversorgung notwendig sind, auch stückweise herzustellen sind.

Beispielsweise werden rohrförmige emaillierte Bauteile zu einer Verbindungsleitung zusammengefügt. Die Rohrleitung nimmt dann das notwendige Kühlmittel, flüssigen Stickstoff auf. Die Emailschicht stellt dann erfindungsgemäß eine supraleitende Verbindung dar.

Mit dem Verfahren nach der Erfindung und mit den mit diesem Verfahren hergestellten hochtemperatursupraleitenden Bauteilen wird insbesondere der Vorteil erzielt, daß der Effekt der Supraleitung bei hohen Temperaturen kommerziell einsetzbar ist, da hochtemperatursupraleitende Bauteile und Verbindungsleitungen als Massengut im Fließbandverfahren herstellbar sind.

Beispiele für das Verfahren und für ein Bauteil nach der Erfindung werden anhand der Zeichnung näher erläutert:

Die FIG 1, 2 und 3 zeigen Beispiele für den Temperaturverlauf bei der glaskeramischen Wärmebehandlung einer Fritte in Abhängigkeit von der Zeit.

Die FIG 4 zeigt im Querschnitt eine mit dem Verfahren nach der Erfindung hergestellte hochtemperatursupraleitende Verbindungsleitung.

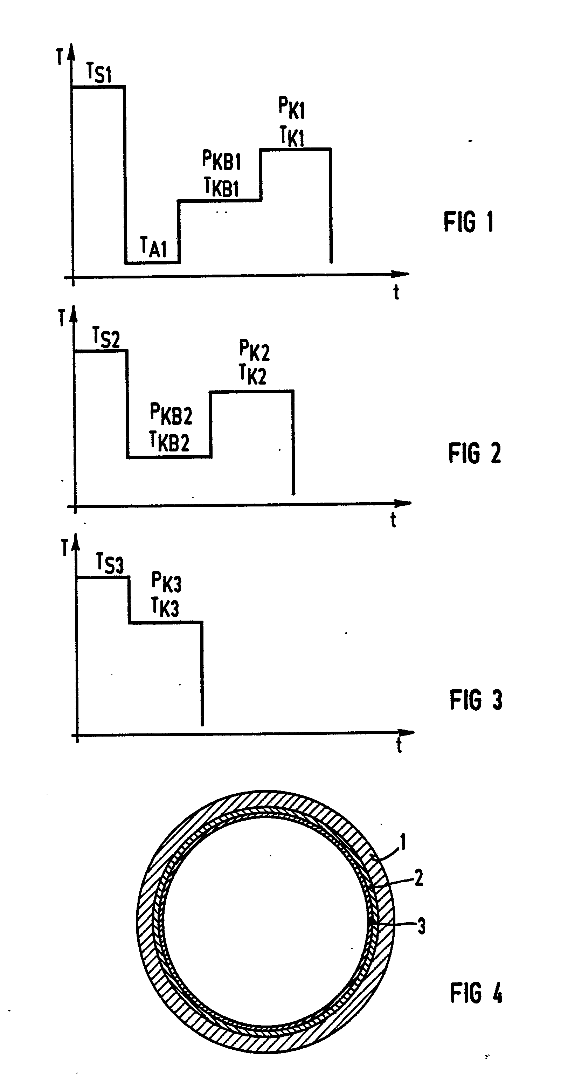

Eine zuvor hergestellte Fritte wird einer Wärmebehandlung unterzogen. Nach FIG 1 wird bei einer glaskeramischen Wärmebehandlung zunächst die Schmelztemperatur $T_{S1}$ der Fritte eingestellt. Damit man eine glasige Fritte erhält, wird die geschmolzene Fritte von der Schmelztemperatur $T_{S1}$ ausgehend abgeschreckt und dadurch auf die Anlaßtemperatur $T_{A1}$ abgekühlt. Anschließend erfolgt eine Erwärmung bis zur Keimbildungstemperatur $T_{KB1}$. Bei Erreichen dieser Temperatur wird ein festgelegter Keimbildungs-Sauerstoffpartialdruck $P_{KB1}$ über der Fritte eingestellt, damit die Keimbildung erfolgen kann. Nach der Keimbildung wird die Fritte bis zur Kristallisationstemperatur $T_{K1}$ erwärmt und es wird ein Kristallisations-Sauerstoffpartialdruck $P_{K1}$ eingestellt. Abschließend erfolgt eine Abkühlung der fertigen Glaskeramik.

Nach FIG 2 wird die Fritte mit einer glaskeramischen Wärmebehandlung bei der Schmelztemperatur $T_{S2}$ oder darüber aufgeschmolzen und wird dann gleich durch Abschrecken auf die Keimbildungstemperatur $T_{KB2}$ gebracht, wobei der Keimbildungs-Sauerstoffpartialdruck $P_{KB2}$ eingestellt wird. Nach der Keimbildung wird die Fritte bis zur Kristallisationstemperatur $T_{K2}$ erwärmt und es wird der Kristallisations-Sauerstoffpartialdruck $P_{K2}$ eingestellt. Abschließend erfolgt eine Abkühlung.

Nach FIG 3 wird die Fritte bei der Schmelztemperatur $T_{S3}$ oder darüber aufgeschmolzen und wird dann gleich auf die Kristallisationstemperatur $T_{K3}$ abgekühlt, wobei der Kristallisations-Sauerstoffpartialdruck $P_{K3}$ herrscht. In diesem Zustand wird ein Kristallisationsförderer zugegeben. Eine Keimbildungsstufe kann daher entfallen. Danach erfolgt eine Abkühlung.

Eine Kristallisation kann auch schon bei Schmelztemperatur $T_S$ erfolgen, falls ein geeigneter Kristallisations-Sauerstoffpartialdruck $P_K$ eingestellt wird. Während das Schmelzen z.B. unter Heliumgas erfolgt, das einen sehr geringen Sauerstoffpartialdruck aufweist, erfolgt die Kristallisation bei gleichbleibender Temperatur unter einem Gasgemisch, das einen geeigneten Kristallisations-Sauerstoffpartialdruck aufweist.

Nach FIG 4 hat das Trägermetall die Form eines Rohres 1, das einseitig mit einer in Emailliertechnik aufgebrachten Schicht 2 aus bei hohen Temperaturen supraleitendem, keramischem Material versehen ist. Die Schicht 2 befindet sich auf der Innenwand des Rohres 1. Eine gleichartige Schicht kann auch beidseitig auf der Rohrwand angebracht sein. Durch das Rohr 1 ist flüssiger Stickstoff zu leiten, der die Schicht 2 unter die Sprungtemperatur abkühlt, wodurch eine supraleitende Verbindung entsteht. Um mechanische Beschädigungen zu vermeiden, ist die supraleitende Schicht 2 mit einer gut wärmeleitenden Schutzschicht 3, die z.B. aus einem Kunststoff besteht, überdeckt.

Das Rohr 1 kann, wie dargestellt, einen runden Querschnitt, aber auch einen kastenförmigen oder gewellten Querschnitt haben. Auch kann das Rohr wabenförmig unterteilt sein. Statt der Form eines Rohres 1 kann das Trägermetall die Form eines Bleches, eines Bandes oder eines Drahtes haben.

Supraleitende Bauteile können, beispielsweise zum Aufbau einer Verbindungsleitung, aneinander gefügt werden. Das Rohr 1 nimmt dann Kühlmittel auf.

**Ansprüche**

1. Verfahren zum Herstellen eines hochtemperatursupraleitenden Bauteiles, das aus einem mit supraleitendem, keramischem Material beschichteten Trägermetall besteht, **dadurch gekennzeich-**

net, daß das keramische Material in Emailliertechnik oder in einer Kombination aus Emailliertechnik und Glaskeramiktechnik auf das Trägermetall aufgebracht wird.

2. Verfahren nach Anspruch 1, **dadurch gekennzeichnet,** daß anorganische Verbindungen, die Komponenten eines supraleitenden, keramischen Materials sind, geschmolzen werden, daß die Schmelze zur Herstellung einer Fritte pulverisiert wird, daß die Fritte dann auf das Trägermetall als Schicht (2) aufgebracht wird, und daß das mit der Fritte versehene Trägermetall einer Wärmebehandlung unterzogen wird, wobei die Fritte schmilzt und auf dem Trägermetall eine Emailschicht bildend kristallisiert.

3. Verfahren nach Anspruch 2, **dadurch gekennzeichnet,** daß der Fritte Zusatzstoffe beigemischt werden.

4. Verfahren nach einem der Ansprüche 2 und 3, **dadurch gekennzeichnet,** daß der Fritte Kristallisationsförderer zugegeben werden.

5. Verfahren nach einem der Ansprüche 2 bis 4, **dadurch gekennzeichnet,** daß auf die Partikel der Fritte elektrisch isolierende Schichten aufgebracht werden.

6. Verfahren nach Anspruch 5, **dadurch gekennzeichnet,** daß die elektrisch isolierenden Schichten elektrostatisch aufgebracht werden.

7. Verfahren nach einem der Ansprüche 2 bis 6, **dadurch gekennzeichnet,** daß die Fritte auf das Trägermetall durch Schlickertauchen, durch Elektrophorese oder elektrostatisch aufgebracht wird.

8. Verfahren nach einem der Ansprüche 2 bis 7, **dadurch gekennzeichnet,** daß die Wärmebehandlung bei ausgewählten Temperaturen und unter ausgewählten Sauerstoffpartialdrücken erfolgt.

9. Verfahren nach Anspruch 8, **dadurch gekennzeichnet,** daß bei einer glaskeramischen Wärmebehandlung das mit der Fritte beschichtete Trägermetall bis auf eine Temperatur, die genau so groß oder größer als die Schmelztemperatur ($T_{S2}$) der Fritte ist, erwärmt wird, um die aus der Fritte gebildete Schicht (2) zu schmelzen, daß dann die Temperatur bis auf eine Keimbildungstemperatur ($T_{KB2}$) erniedrigt wird, um Kristallisationskeime des supraleitenden Materials mit hoher Keimbildungsgeschwindigkeit entstehen zu lassen, daß danach die Temperatur auf eine Kristallisationstemperatur ($T_{K2}$) erhöht wird, die kleiner als die Schmelztemperatur ($T_{S2}$) ist, um eine hohe Kristallisationsrate des supraleitenden Materials zu erzielen und daß dann die Temperatur erniedrigt wird.

10. Verfahren nach Anspruch 8, **dadurch gekennzeichnet,** daß das mit der Fritte beschichtete Trägermetall nach einer Erwärmung auf eine Temperatur, die genau so groß oder größer als die Schmelztemperatur ($T_{S1}$) ist, auf eine Anlaßtemperatur ($T_{A1}$), die kleiner als eine Keimbildungstemperatur ($T_{KB1}$) ist, abgekühlt wird und daß dann eine Erwärmung auf diese Keimbildungstemperatur ($T_{KB1}$) und danach auf eine Kristallisationstemperatur ($T_{K1}$) erfolgt und daß dann die Temperatur erniedrigt wird.

11. Verfahren nach Anspruch 8, **dadurch gekennzeichnet,** daß zur Wärmebehandlung das mit der Fritte beschichtete Trägermetall bis auf eine Temperatur, die genau so groß oder größer als die Schmelztemperatur ($T_{S3}$) der Fritte ist, erwärmt wird, um die aus der Fritte gebildete Schicht (2) zu schmelzen und daß dann die Temperatur bis auf eine Kristallisationstemperatur ($T_{K3}$) erniedrigt wird, wobei zuvor ein Kristallisationsförderer zugemischt wird, der als Keimbildner wirkt und daß dann die Temperatur weiter erniedrigt wird.

12. Verfahren nach einem der Ansprüche 8, 9 und 10, **dadurch gekennzeichnet,** daß die Keimbildungstemperatur ($T_{KB}$) unter einem bestimmten Keimbildungs-Sauerstoffpartialdruck ($p_{KB}$) eingestellt wird.

13. Verfahren nach einem der Ansprüche 8 bis 11, **dadurch gekennzeichnet,** daß die Kristallisationstemperatur ($T_K$) unter einem Kristallisations-Sauerstoffpartialdruck ($p_K$) eingestellt wird.

14. Verfahren nach Anspruch 8, **dadurch gekennzeichnet,** daß die Wärmebehandlung bei einer gleichbleibenden ausgewählten Temperatur und bei sich änderndem Sauerstoffpartialdruck erfolgt.

15. Hochtemperatursupraleitendes Bauteil, bestehend aus einem mit supraleitendem, keramischem Material beschichteten Trägermetall, hergestellt mit dem Verfahren nach einem der Ansprüche 1 bis 14, **dadurch gekennzeichnet,** daß ein Trägermetall mit einem in Emailliertechnik oder in einer Kombination aus Emailliertechnik und Glaskeramiktechnik aufgebrachten, supraleitenden, keramischen Material beschichtet ist.

16. Hochtemperatursupraleitendes Bauteil nach Anspruch 15, **dadurch gekennzeichnet,** daß das Trägermetall die Form eines Bleches, eines Bandes oder eines Drahtes hat.

17. Hochtemperatursupraleitendes Bauteil nach Anspruch 15, **dadurch gekennzeichnet,** daß das Trägermetall die Form eines Rohres (1) hat.

18. Hochtemperatur supraleitendes Bauteil nach Anspruch 17, **dadurch gekennzeichnet,** daß das Rohr (1) einen runden, kastenförmigen oder gewellten Querschnitt hat.

19. Hochtemperatursupraleitendes Bauteil nach einem der Ansprüche 17 oder 18, **dadurch gekennzeichnet,** daß das Rohr wabenförmig unterteilt ist.

20. Hochtemperatursupraleitendes Bauteil nach einem der Ansprüche 15 bis 19, **dadurch gekenn-**

zeichnet, daß das Trägermetall einseitig oder beidseitig beschichtet ist.

21. Hochtemperatursupraleitendes Bauteil nach einem der Ansprüche 15 bis 20, **dadurch gekennzeichnet,** daß das Trägermetall Kupfer enthält.

22. Hochtemperatursupraleitendes Bauteil nach einem der Ansprüche 15 bis 21, **dadurch gekennzeichnet,** daß das supraleitende keramische Material Y-Ba-Cu-Oxid, Bi-Sr-Ca-Cu-Oxid oder Tl-Ba-Ca-Cu-Oxid ist.

23. Hochtemperatursupraleitendes Bauteil nach einem der Ansprüche 15 bis 22, **dadurch gekennzeichnet,** daß an das Bauteil ein weiteres hochtemperatursupraleitendes Bauteil anzufügen ist.

24. Hochtemperatursupraleitendes Bauteil nach einem der Ansprüche 17 bis 23, **dadurch gekennzeichnet,** daß das Bauteil die Form eines Rohres (1) hat und mit weiteren rohrförmigen hochtemperatursupraleitenden Bauteilen, die aneinander gefügt sind, eine hochtemperatursupraleitende Verbindungsleitung bildet, die ein Kühlmittel aufnimmt.

FIG 1

$T_{S1}$

$P_{K1}$
$T_{K1}$

$P_{KB1}$
$T_{KB1}$

$T_{A1}$

FIG 2

$T_{S2}$

$P_{K2}$
$T_{K2}$

$P_{KB2}$
$T_{KB2}$

FIG 3

$T_{S3}$

$P_{K3}$
$T_{K3}$

FIG 4

1
2
3

Europäisches
Patentamt

**EUROPÄISCHER RECHERCHENBERICHT**

Nummer der Anmeldung

EP 88 12 1551

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 289 412 (SUMITOMO) <br> * Spalte 9, Zeile 59 - Spalte 10, Zeile 22 * <br> --- | 1,2,7, 15 | H 01 L 39/24 <br> C 04 B 35/00 <br> C 23 D 5/00 |
| A | GB-A-2 022 486 (GENERAL ELECTRIC) <br> * Zusammenfassung * <br> --- | 1,2,7-11,15, 16 | |
| A | K.A. MASKALL et al.: "Vitreous Enamelling: A Guide to Modern Enamelling Practice", 1986, Seiten 79-91, Kapitel 6, Pergamon Press, Oxford, GB; "Application and fusing of enamel" <br> * Seiten 83-84,86 * <br> ----- | 1,2,7-11,15 | |

| | |
|---|---|
| | **RECHERCHIERTE SACHGEBIETE (Int. Cl.5)** <br><br> H 01 L <br> C 23 D |

Der vorliegende Recherchenbericht wurde für alle Patentansprüche erstellt

| Recherchenort | Abschlußdatum der Recherche | Prüfer |
|---|---|---|
| DEN HAAG | 23-08-1989 | HARRISON R.J. |